# EUROPÄISCHE PATENTSCHRIFT

(11) **EP 3 882 982 B1**
(45) Veröffentlichungstag und Bekanntmachung des Hinweises auf die Patenterteilung: **23.09.2026**
(21) Anmeldenummer: 21000072.5
(22) Anmeldetag: 12.03.2021
(51) Int. Cl.: H10D 8/00, H10D 8/01, H10D 62/10, H10D 62/824, H10D 62/85, H10D 62/852, H10D 64/00, H10F 10/163, H10F 77/124, H10F 77/30, H10F 30/221, H10D 62/40

(54) **STAPELFÖRMIGES PHOTONISCHES III-V-HALBLEITERBAUELEMENT**
STACKED PHOTONIC III-V SEMI-CONDUCTOR MODULE
COMPOSANT PHOTONIQUE EMPILÉ À SEMI-CONDUCTEUR III-V

(30) Priorität: 20.03.2020 DE 102020001842
(43) Veröffentlichungstag der Anmeldung: 22.09.2021
(73) Patentinhaber: AZUR SPACE Solar Power GmbH, 74072 Heilbronn (DE)
(72) Erfinder: Strobl, Gerhard, 70439 Stuttgart (DE)
(74) Vertreter: Koch Müller Patentanwaltsgesellschaft mbH

(56) Entgegenhaltungen:
- US-A1- 2007 278 626
- US-A1- 2010 213 513
- US-B2- 6 998 320
- YUAN HENRY ET AL: "FPA development: from InGaAs, InSb, to HgCdTe", PROCEEDINGS OF SPIE, vol. 6940, 3 April 2008 (2008-04-03), US, pages 69403C, XP055830306, ISSN: 0277-786X, ISBN: 978-1-5106-4374-1, DOI: 10.1117/12.782735
- ROUVIÉ ANNE ET AL: "InGaAs focal plane array developments at III-V Lab", PROCEEDINGS OF SPIE, vol. 8353, 1 May 2012 (2012-05-01), US, pages 835308, XP055830305, ISSN: 0277-786X, ISBN: 978-1-5106-4374-1, DOI: 10.1117/12.921134

## Beschreibung

Die Erfindung betrifft ein stapelförmiges photonisches III-V-Halbleiterbauelement.

III-V-Halbleiterdioden werden inzwischen mit jeweils angepassten Parametern in den verschiedensten Bereichen eingesetzt.

Aus "GaAs Power Devices" von German Ashkinazi, ISBN 965-7094-19-4, Seite 8 und 9 ist ein hochspannungsfestes Halbleiterbauelement aus GaAs mit p⁺ - n - n⁺ bekannt.

Weitere hochspannungsfeste III-V- Halbleiterbauelemente und entsprechende Herstellungsverfahren sind auch aus den Druckschriften DE 10 2016 013 540 A1, DE 10 2016 013 541 A1, DE 10 2016 015 056 A1, DE 10 2017 002 935 A1 und DE 10 2017 002 936 A1 bekannt.

Aus der US 2007/278626 A1; der US 6 998 320 B2; der US 2010/213 513 A1; aus Yuan Henry et al "FPA development: from InGaAs, InSb to HgCdTe",PROCEEDINGS OF SPIE, Bd. 6940, 03.04.2008, S. 6940C, XP055830306 US, ISBN: 978-1-5106-4374; aus Rouvié Anne et al: "InGaAs focal plane array developments at III-V Lab", PROCEEDINGS OF SPIE Bd. 8353, 01.05.2012, S. 835308, XP055830305 US, ISBN: 978-1-5106-4374-1 sind weitere III-V Halbleiterbauelemente bekannt

Insbesondere offenbart die US 2007/278626 A1 ein stapelförmiges photonisches III-V-Halbleiterbauelement mit einem Halbleiterkontaktgebiet, das sich in ein Absorptionsgebiet erstreckt. Das Bauelement umfasst eine III-V-Halbleiterpassivierungsschicht auf der Oberfläche des Absorptionsgebiets, die die gleiche Gitterkonstante des Halbleiterkontaktgebiets aufweist aber eine unterschiedliche Energiebandlücke.

III-V- Halbleiterbauelemente werden auch als Pixel bzw. Halbleiterdetektoren in 2D-Pixel-Array-Detektoren eingesetzt.

Beispielsweise sind Infrarotdetektoren aus "InGaAs NIR focal plane arrays for imaging and DWDM applications", Barton et al., Infrared Detectors and Focal Plane Arrays VII, Proc. of SPIE Vol. 4721, 2002, bekannt.

Die beschriebenen III-V-Halbleiterdiodenstrukturen weisen jeweils ein gitterangepasstes InGaAs Absorptionsgebiet auf einen n+ dotiertem InP Substrat, ein durch Diffusion erzeugtes p+ Kontaktgebiet und eine III-V-Halbleiterpassivierungsschicht auf. Entsprechende Infrarotdetektoren sind auch aus "Multiplexed 256 Element InGaAs Detector Arrays for 0.8 - 1.7 um Room-Temperature Operation", Olsen et al., Infrared Technology XIV, SPIE Vol. 972, 279 und aus "InGaAs focal plane arrays developments at III-VLab", Rouvie et al., Infrared Technology and Applications XXXVIII, Proc. of SPIE Vol. 8358, 835308, 2012, doi: 10.1117/12.921134 bekannt.

Auch aus "FPA Development from InGaAs InSb to HgCdTe", Yuan et al., Infrared Technology and Applications XXXIV, Proc. of SPIE Vol. 6940, 69403C, 2008, doi: 10.1117/12.782735 ist ein Infrarotdetektor bekannt, wobei verschiedene p-i-n Strukturen mit InGaAs mit unterschiedlichem Indium-Gehalt als Absorptionsgebiet auf einem InP Substrat gegebenenfalls mit einer Pufferschicht, sowie Pixel-Arrays auf Basis von InSb und HgCdTe beschrieben werden.

Aus "A Method for Adjusting the Performance of Epitaxial GaAs X-ray Detecotrs", Sun,G.C. and Bourgoin,J.C., Nucl. Instrum. Methods Phys. Res., Sect. A, 2003, vol. 512, pp. 355-360, aus "GaAs Schottky versus p/i/n Diodes for Pixellated X-ray Detectors", Bourgoin,J.C. and Sun,G.C., Nucl. Instrum. Methods Phys. Res., Sect. A, 2002, vol. 487, pp. 47-49, ebenso aus der DE 602 21 638 T2, ist ein Verfahren und Gerät zur Herstellung eines GaAs-Detektors für eine Röntgenstrahl-Erfassung und eine Bildaufnahme bekannt. Des Weiteren ist aus der WO 2004 816 04 A2 eine weitere GaAs-Bildaufnahmevorrichtung zur Detektion von Röntgenstrahlung bekannt.

Als Pixel eines Röntgendetektors sind p-i-n Strukturen aus einer GaAs-Verbindung aus "GaAs Pixel-Detector Technology for X-ray Medical Imaging", Lezhneva et al.,a Russian Microelectronics, Vol. 34, No. 4, 2005, pp. 229-241, bekannt, wobei sowohl epitaktisch gewachsene als auch implantierte p+ Kontaktgebiet offenbart werden. Alternativ werden GaAs basierte Schottky Dioden offenbart.

Ein ebenfalls auf Schottky-Dioden basierender Röntgendetektor auf GaAs-Basis ist aus "GaAs X-Ray System Detectors for Medical Applications", Rizzi et al., https://www.researchgate.net/publication/237780321, bekannt.

Nachteilig an den beschriebenen Strukturen sind die Rest- bzw. Leckströme, die bei einem Betrieb in Sperrrichtung, insbesondere über die Ränder der planaren p-n Übergänge bzw. der Mesa-Strukturen auftreten.

Vor diesem Hintergrund besteht die Aufgabe der Erfindung darin, eine Vorrichtung anzugeben, die den Stand der Technik weiterbildet. Ziel ist insbesondere eine Reduktion von Sperrströmen und eine Steigerung der Durchbruchspannung.

Die Aufgabe wird durch ein stapelförmiges photonisches III-V-Halbleiterbauelement mit den Merkmalen des Patentanspruchs 1 gelöst. Vorteilhafte Ausgestaltungen der Erfindung sind Gegenstand von Unteransprüchen.

In dem Gegenstand der Erfindung wird ein stapelförmiges photonisches III-V-Halbleiterbauelement bereitgestellt.

Das stapelförmige photonische III-V-Halbleiterbauelement weist eine zumindest gebietsweise ausgebildete zweite metallische Anschlusskontaktschicht, ein hochdotiertes erstes Halbleiterkontaktgebiet, ein Absorptionsgebiet und eine erste metallische Anschlusskontaktschicht auf.

Die erste Halbleiterkontaktschicht weist einen ersten Leitfähigkeitstyps mit einer Dotierstoffkonzentration von mindestens 5•10¹⁸ cm⁻³, eine erste Gitterkonstanten und eine erste Energiebandlücke auf.

Das Absorptionsgebiet weist einen zweiten Leitfähigkeitstyp oder den ersten Leitfähigkeitstyp auf, wobei eine Dotierstoffkonzentration in dem Absorptionsgebiets zwischen 8•10¹¹ und 5•10¹⁴ cm⁻³ beträgt. Vorzugsweise weist das Absorptionsgebiet eine gleichmäßige Dotierstoffkonzentration auf. In einer anderen Ausführungsform ist die Dotierstoffkonzentration über die Dicke des Absorptionsgebietes unterschiedlich hoch.

Wenn das Absorptionsgebiet den ersten Leitfähigkeitstyp aufweist, weist das stapelförmige photonische III-V-Halbleiterbauelement eine hoch-dotierte Halbleiterkontaktschicht des zweiten Leitfähigkeitstyps auf, die unterhalb einer Unterseite des Absorptionsgebiets angeordnet und mit einer Oberseite der ersten metallischen Anschlusskontaktschicht verbunden ist. Außerdem bestehen die Halbleiterkontaktgebiete bzw. Halbleiterschichten des photonischen III-V - Bauelements aus III-V Materialien

Das Absorptionsgebiet weist die erste Gitterkonstante und eine Schichtdicke in einem Bereich zwischen 80 µm und 2000 µm, bevorzugt von 100 µm bis 2000 µm oder von 500 µm bis 2000 µm oder von 1000 µm bis 2000 µm auf.

Das erste Halbleiterkontaktgebiet ist wannenförmig mit einer Oberseite und einer sich in das Absorptionsgebiet hinein erstreckenden Tiefe ausgebildet. Bevorzugt ist die Oberseite des ersten Halbleiterkontaktgebiets vollständig von einer Oberseite des Absorptionsgebiets umgebenen.

Die Unterseite der zweiten metallischen Anschlusskontaktschicht ist stoffschlüssig mit der Oberseite des ersten Halbleiterkontaktgebiets verbunden.

Die erste metallische Anschlusskontaktschicht ist unterhalb einer Unterseite des Absorptionsgebiets angeordnet.

Das stapelförmige photonische III-V-Halbleiterbauelement weist außerdem eine III-V-Halbleiterpassivierungsschicht mit der ersten Gitterkonstanten und einer sich von der ersten Energiebandlücke unterscheidenden zweiten Energiebandlücke auf, wobei die III-V-Halbleiterpassivierungsschicht den ersten oder den zweiten Leitfähigkeitstyp und eine Dotierstoffkonzentration in einem Bereich zwischen 1•10¹⁴ cm⁻³ und 5•10¹⁸ cm⁻³ aufweist.

Die III-V-Halbleiterpassivierungsschicht ist in einem ersten Abstand von mindestens 10 µm oder von mindestens 20 µm oder von mindestens 40 µm zu der Oberseite des erste Halbleiterkontaktgebiets auf der Oberseite des Absorptionsgebiets angeordnet und mit der Oberseite des Absorptionsgebiets stoffschlüssig verbunden ist.

Bevorzugt beträgt der erste Abstand zwischen der III-V-Halbleiterpassivierungsschicht und der Oberseite des ersten Halbleiterkontaktgebiets maximal 40 µm oder maximal 80 µm oder maximal 150 µm oder maximal 1500 µm oder maximal 2000 µm.

Es sei angemerkt, dass die metallischen Anschlusskontaktschichten jeweils elektrisch sehr gut leitfähig sind. Bevorzugt bestehen die metallischen Anschlusskontaktschichten aus einer oder mehreren Metallschichten, wobei die Metallschichten bevorzugt Ge und/oder Au und/oder Pd und/oder Ag umfassen.

Die metallischen Anschlusskontaktschichten stellen zu dem hochdotierten erste Halbleiterkontaktgebiet sowie zu einer weiteren dotierten Halbleiterschicht, z.B. einer hochdotierten zweiten Halbleiterkontaktschicht oder dem sehr niedrig dotierten Absorptionsgebiet, einen elektrisch niederohmigen Kontakt her. Es versteht sich, dass die jeweilige Halbleiterschicht hierfür jeweils unmittelbar an die entsprechende metallische Anschlusskontaktschicht angrenzt, d.h. stoffschlüssig mit dieser verbunden ist.

Des Weiteren versteht es sich, dass die Anschlusskontaktschichten mittels Bonddrähte mit Kontaktfingern, den sogenannten Pins, und/oder mittels Kontaktpunkten, sogenannten Bumps, mit Flip-Chip-Montage verschaltet sind, indem vorzugsweise mehrere bzw. eine Vielzahl von photonischen Bauelemente auf einem Träger beispielsweise in Form eines Leadframes angeordnet sind. In einer Ausführungsform sind die photonischen Bauelemente matrixförmig angeordnet.

Das erste Halbleiterkontaktgebiet ist als in das Absorptionsgebiet hineinreichendes Gebiet ausgebildet, so dass die Oberseite des ersten Halbleiterkontaktgebiets und die Oberseite des Absorptionsgebiets eine gemeinsame Oberfläche ausbilden bzw. sich die Oberseite des ersten Halbleiterkontaktgebiets inselförmig innerhalb der Oberseite des Absorptionsgebiets befindet.

Es versteht sich jedoch, dass das erste Halbleiterkontaktgebiet immer durch eine von dem Absorptionsgebiet gebildete Oberfläche von der III-V-Halbleiterpassivierungsschicht beabstandet ist. Anders ausgedrückt die III-V-Halbleiterpassivierungsschicht ist von der Kante des erste Halbleiterkontaktgebietes immer mit mindestens 10 µm beabstandet. Maximal ist der Abstand so groß wie die Dicke des Absorptionsgebiets.

Das erste Halbleiterkontaktgebiet reicht von der Oberseite bis zu einer maximalen Tiefe in das Absorptionsgebiet hinein, wobei die Schichtdicke des Absorptionsgebiets deutlich größer ist als die Tiefe des ersten Halbleiterkontaktgebiets.

Vorzugsweise an einer in Richtung des ersten Halbleiterkontaktgebiets ausgebildeten Kante der III-V-Halbleiterpassivierungsschicht weist die ansonsten plane Oberfläche des Absorptionsgebiets eine entlang der Kante ausgebildete umlaufende Stufe auf.

Das erste Halbleiterkontaktgebiet ist bevorzugt mittels Implantation oder durch Diffusion erzeugt. Die weiteren Halbleitergebiete bzw. Halbleiterschichten, z.B. das Absorptionsgebiet und/oder die III-V-Halbleiterpassivierungsschicht sind bevorzugt teilweise oder vollständig epitaktisch, z.B. mittels MOVPE oder mittels CSVT (Closed Space Vapour Transport) oder mittels LPE, erzeugt.

Als Aufwachssubstrat wird beispielsweise ein GaAs-Substrat oder ein Ge-Substrat verwendet. Im Falle des GaAs Substrats können aktive Schichten aus GaAs direkt auf dem Substrat abgeschieden werden. Im Falle des Ge Substrates bedarf es zum Aufwachsen von GaAs-Schichten einer InGaAs-Zwischenschicht mit ca. 1% In Anteil, um einen Gitterkonstantenunterschied zwischen Ge Substrat und GaAs-Epitaxieschicht zu erhalten.

Das Aufwachssubstrat wird anschließend durch Schleifen und / oder Ätzen und / oder andere Prozesse, z.B. Ablösen, bevorzugt vollständig, gegebenenfalls auch nur teilweise entfernt.

In einer Ausführungsform wird hierfür während eines Herstellprozesses des stapelförmigen III-V-Halbleiterbauelements eine Ätzstoppschicht unterhalb des Absorptionsgebiets eingefügt. Die Ätzstoppschicht wird beispielsweise zwischen dem Absorptionsgebiet und einer Pufferschicht oder einer Substratschicht oder zwischen einer zweiten Halbleiterkontaktschicht und einer Pufferschicht oder einer Substratschicht oder zwischen einer Pufferschicht und einer Substratschicht erzeugt.

Die Ätzstoppschicht ermöglicht ein nachfolgendes Ablösen der Substratschicht und der Pufferschicht oder nur der Substratschicht mittels eines Ätzprozesses, z.B. nasschemisches Ätzen. Insbesondere ermöglicht es die Ätzstoppschicht, Substrat und/oder Pufferschicht ohne eine mechanischen Schleifprozess zu entfernen oder einen mechanischen Schleifprozess mit einem Ätzschritt zu kombinieren, z.B. wird der größte Teil des Substrates durch Schleifen und nur der verbleibende Rest durch chemisches Ätzen entfernt.

Die Ätzstoppschicht selbst kann danach auch entfernt werden. Die Ätzstoppschicht weist eine starke chemische Anisotropie gegenüber den angrenzenden Schichten auf, das heißt die Ätzrate für die Ätzstoppschicht und die anschließende Schicht unterscheiden sich mindestens um einen Faktor 10.

Die Ätzstoppschicht besteht üblicherweise aus GaInP oder AlGaAs und die umgebenden Schichten aus GaAs oder GaInAs. Die entfernten Schichten sind in dem finalen Bauelement nicht mehr vorhanden.

Die Halbleiterschichten des Bauelements, beispielsweise aus GaAs, werden beispielsweise epitaktisch erzeugt. Später wird beispielsweise zuerst das Ge-Substrat mittels eines Schleif- und/oder Ätzprozesses entfernt und gegebenenfalls danach mittels eines weiteren Ätzprozesses, z.B. nasschemisches Ätzen, eine Pufferschicht-Schicht von dem photonischen GaAs-Bauelement entfernt.

Alternativ zu dem vollständigen Entfernen des Aufwachssubstrats wird das Aufwachssubstrat, z.B. ein mit dem zweiten Leitfähigkeitstyp dotiertes GaAs-Substrat, nur teilweise entfernt, so dass eine verbleibende, z.B. dünne bis sehr dünne, Schicht eine hochdotierte zweite Halbleiterkontaktschicht des zweiten Leitfähigkeitstyps ausbildet.

Alternativ oder ergänzend sind eine oder mehrere Schichten des stapelförmigen photonischen III-V-Halbleiterbauelements mittels eines Wafer-Bonds miteinander verbunden.

Auch sei angemerkt, dass der Ausdruck "Halbleiterschicht" mit dem Ausdruck "Halbleitergebiet" vorzugsweise synonym verwendet wird. Jedoch wird mit dem Ausdruck "Halbleitergebiet" eine im Allgemeinen wannenförmige Ausbildung des Zwischenbereichs und mit dem Ausdruck "Halbleiterschicht" im Allgemeinen eine Schicht zumindest mit einer planen Unterseite und / oder mit einer planen Oberseite bezeichnet.

Vorzugsweise sind die III-V Halbleiterschichten jeweils zueinander zumindest teilweise planar oder teilweise wannenförmig ausgebildet, wobei die laterale Ausbildung der jeweiligen III-V Halbleiterschichten für die planare Anordnung vorzugsweise gleich groß ist.

Erfindungsgemäß bestehen die Halbleiterbereiche bzw. Halbleiterschichten des photonischen III-V-Bauelements aus III-V-Materialien, z.B. GaAs, AlGaAs, InGaP, GaAsP, InGaAs oder InP. Das photonische III-V-Halbleiterbauelement kann zusätzliche Schichten aus anderen nicht-HalbleiterMaterialien umfassen.

Außerdem versteht es sich, dass ein aus einem III-V-Material bestehendes Halbleitergebiet bzw. eine Halbleiterschicht nur im Wesentlichen aus III-V-Material bestehen muss bzw. neben einem III-V-Material, also einem Material welches einen oder mehrere Elemente der III. und/oder V. Hauptgruppe umfasst, gegebenenfalls noch Verunreinigungen, Störstellen und/oder Dotierstoffe aufweisen kann.

Entsprechendes gilt für ein aus GaAs oder einer anderen ausdrücklich genannten Materialkombination bestehenden Halbleitergebiet bzw. eine Halbleiterschicht. Weist eine Schicht eine ausdrücklich genannte Materialkombination auf, so wird damit ausgedrückt, dass das Material der Schicht im Wesentlichen aus einer Verbindung der ausdrücklich genannten Materialien und gegebenenfalls weiteren Elementen der III. und/oder V. Hauptgruppe besteht. Eine GaAs aufweisende Schicht kann also beispielsweise eine InGaAs-Schicht sein.

Niedrig dotierte dicke Schichten, wie die erfindungsgemäße Absorptionsschicht, lassen sich inzwischen beispielsweise mittels MOVPE abscheiden, wodurch sich Schichtstapel auf einfache Weise erzeugt lassen. Je niedriger die Schicht dotiert ist, desto geringer ist die benötigte Sperrspannung, um ein größtmögliches elektrisches Feld aufzubauen. Die Schichten können im Nachgang auch noch durch Elektronen mit z.B. 1MeV bestrahlt werden, um EL2 Rekombinationszentren gleichmäßig über die gesamte Schichtdicke zu erzeugen, die dann durch das Einfangen eines Elektrons oder eines Lochs den Dotierlevel der dicken Schicht noch weiter sehr definiert absenken.

Erfindungsgemäß ist das photonische III-V-Halbleiterbauelement mit einer n-auf-p oder einer p-auf-n Struktur ausgebildet.

Entsprechend ist entweder der erste Leitfähigkeitstyp n und der zweite Leitfähigkeitstyp p oder vice versa.

Weist das Halbleiterbauelement keine zusätzliche zweite Halbleiterkontaktschicht auf, so unterscheidet sich der Leitfähigkeitstyp des Absorptionsgebiets von dem Leitfähigkeitstyp des ersten Halbleiterkontaktgebiets, d.h. das Absorptionsgebiet weist den zweiten Leitfähigkeitstyp auf und der p-n Übergang bildet sich zwischen dem ersten Halbleiterkontaktgebiet und dem Absorptionsgebiet aus.

Weist das Halbleiterbauelement eine zweite Halbleiterkontaktschicht auf, so kann der p-n Übergang entweder zwischen dem Absorptionsgebiet und dem ersten Halbleiterkontaktgebiet oder zwischen dem Absorptionsgebiet und der zweiten Halbleiterkontaktschicht ausgebildet werden, wobei das Absorptionsgebiet entsprechend entweder den zweiten oder den ersten Leitfähigkeitstyp aufweist. Das Halbleiterbauelement, das sowohl die zweite Halbleiterkontaktschicht als auch den p-n Übergang zwischen dem ersten Halbleiterkontaktgebiet und dem Absorptionsgebiet aufweist, ist allerdings nicht von den Ansprüchen abgedeckt.

Gegebenenfalls durch den lokalen p-n Übergang zwischen dem erste Halbleiterkontaktgebiet und der Absorptionsschicht und insbesondere durch die III-V-Halbleiterpassivierungsschicht werden Leckströme im Randbereich bzw. über den Rand verlaufende Strompfad unterdrückt.

Untersuchungen haben gezeigt, dass die Durchbruchsspannung nicht nur durch die Dicke des Absorptionsgebiets sondern auch wesentlich durch den ersten Abstand zwischen der III-V-Halbleiterpassivierungsschicht und dem erste Halbleiterkontaktgebiet bestimmt wird.

Mit dem erfindungsgemäßen photonischen Bauelement lassen sich Durchbruchfeldstärken von bis zu 40 V/µm und sehr zuverlässig Durchbruchfeldstärken von über 30 V/µm erreichen.

III-V-Halbleiter, insbesondere GaAs, liefern eine besonders hohe Elektronenbeweglichkeit von 8800 Vs/cm bei einer Dotierung von kleiner als 1•10¹⁵ cm³, wobei die Elektronenbeweglichkeit bei InGaAs von ca. 12.000 Vs/cm bei einer Dotierung von kleiner als 1•10¹⁵ cm⁻³ liegt.

Vorteile der erfindungsgemäßen Halbleiterstruktur sind ein besonders geringer Sperrstrom und eine hohe Durchbruchspannung. Insbesondere weist die Durchbruchkennlinie einen idealen Verlauf auf.

Mit dem besonders dicken Absorptionsgebiet oberhalb von 80 µm bis zu einer Dicke von 2000 µm oder einer Dicke zwischen 100µm und 2000µm und der besonders hohen Sperrspannung eignet sich die erfindungsgemäße Halbleiterstruktur besonders als Pixel zur Strahlungsdetektion insbesondere zur Dedektion von Röntgenstrahlen. Anders ausgedrückt, das photonische Bauelement eignet sich insbesondere als Röntgendetektor.

Indem zwischen der III-V-Halbleiterpassivierungsschicht und dem ersten Halbleiterkontaktgebiet ein Abstand besteht, treten auch bei hohen Sperrspannungen oberhalb von 400 V besonders niedriger Sperrströme von kleiner al 1 µA auf. Insbesondere liegen die Sperrströme in einem Bereich zwischen 0,5 nA und 50 nA oder unterhalb von 100 nA.

Hierdurch lassen sich hohe Rückwärtsspannungen anlegen um die mittels einer Absorption erzeugten Ladungsträger in Richtung des p-n Übergangs zu driften. Es versteht sich, dass sich hierdurch eine sehr hohe Empfindlichkeit des Detektors erzielen lässt.

Die besonders dünne erste metallische Anschlussschicht ist vorzugsweise nicht flächig sondern fingerförmig oder streifenförmig oder punktförmig ausgeführt. Mittels einer dünnen zweiten Halbleiterkontaktschicht oder durch Weglassen der zweiten Hableiterkontaktschicht wird die Durchlässigkeit für Photonen, beispielsweise Röntgenstrahlen, erhöht. Hierdurch lässt sich das erfindungsgemäße photonische Halbleiterbauelement insbesondere als Pixel eines Pixel-Array-Röntgendetektors verwenden. Vorzugsweise weist die erste metallische Anschlussschicht eine Dicke kleiner als 100 µm und größer als 0,1 nm auf.

Es versteht sich außerdem, dass das photonische Bauelement zur Detektion von Strahlen so ausgerichtet wird, dass diese auf die erste metallische Anschlusskontaktschicht und die Unterseite des Bauelements auftreffen. Die Begriffe "unten" und "oben" bzw. "unterhalb" und "oberhalb" dienen lediglich dazu, die Anordnung der einzelnen Schichten und Gebiete zueinander zu beschreiben und geben keine absolute Richtung an.

In einer ersten Ausführungsform weist die III-V-Halbleiterpassivierungsschicht eine Schichtdicke von 0,1 µm - 10 µm auf. Vorzugsweise weist die III-V-Halbleiterpassivierungsschicht eine höhere Bandlücke als das darunterliegende Absorptionsgebiet auf. Insbesondere umfasst die III-V-Halbleiterpassivierungsschicht beispielsweise eine Verbindung aus InGaP und / oder AlGaAs und/oder InGaAsP auf oder besteht aus AlGaAs oder aus InGaP oder aus InGaAsP. In einer andere Weiterbildung sind auf der III-V-Halbleiterpassivierungsschicht auch weitere Passivierungsschichten insbesondere aus Siliziumnitrid und / Oder Siliziumoxid ausgebildet.

In einer anderen Ausführungsform beträgt der erste Abstand der III-V-Halbleiterpassivierungsschicht zu dem ersten Halbleiterkontaktgebiet mindestens 50% oder mindestens 75% der Schichtdicke des Absorptionsgebiets.

Es versteht sich, dass sich der erste Abstand nach der Sperrspannung richtet.

Je größer die Sperrspannung, umso größer muss der erste Abstand sein. Hieraus ergibt sich ein entsprechender Zusammenhang zwischen dem Abstand und der Schichtdicke des Absorptionsbereichs.

In einer weiteren Ausführungsform umschließt die III-V-Halbleiterpassivierungsschicht in einer Projektion senkrecht zu der Oberseite des ersten Halbleiterkontaktgebiets das erste Halbleiterkontaktgebiet vollständig.

Die III-V-Halbleiterpassivierungsschicht weist also in der Projektion eine Durchgangsöffnung auf und das erste Halbleiterkontaktgebiet ist so innerhalb der Durchgangsöffnung angeordnet, dass ein Abstand eines Randes des ersten Halbleiterkontaktgebiets zu einem Rand der Durchgangsöffnung immer größer oder gleich dem ersten Abstand ist.

In einer ersten alternativen Ausführungsform weist die III-V-Halbleiterpassivierungsschicht den gleichen Leitfähigkeitstyp dem Absorptionsgebiet entsprechenden auf. Die III-V-Halbleiterpassivierungsschicht und das Absorptionsgebiet sind also entweder beide p-dotiert oder beide n-dotiert ausgebildet.

Alternativ weist die III-V-Halbleiterpassivierungsschicht einen von dem Absorptionsgebiet abweichenden Leitfähigkeitstyp aufweist, wobei die III-V-Halbleiterpassivierungsschicht stoffschlüssig mit einer zumindest gebietsweise ausgebildeten dritten metallische Anschlusskontaktschicht verbunden ist.

Insbesondere weist das Absorptionsgebiet den ersten Leitfähigkeitstyp und die III-V-Halbleiterpassivierungsschicht den zweiten Leitfähigkeitstyp auf und die dritte metallische Anschlusskontaktschicht ist stoffschlüssig mit der Oberseite der III-V-Halbleiterpassivierungsschicht verbunden.

In einer anderen Ausführungsform ist die III-V-Halbleiterpassivierungsschicht auf dem Absorptionsgebiet und das Absorptionsgebiet auf einer Halbleiterkontaktschicht oder auf einer Pufferschicht oder auf einer Substratschicht epitaktisch angeordnet.

In einer anderen Weiterbildung weist die erste metallische Anschlusskontaktschicht eine Schichtdicke von 5 nm - 2 µm oder von 10 nm - 1 µm auf. Indem bei dem photonischen Bauelement nur sehr geringe Ströme von unterhalb 1 mA vorzugsweise unterhalb 10 µA fließen, sind dünne metallische Anschlusskontaktschichten ausreichend.

In einer alternativen Ausführungsform ist die erste metallische Anschlusskontaktschicht flächig oder fingerförmig oder punktförmig ausgebildet.

Als flächig wird eine Anschlusskontaktschicht bezeichnet, welche die Unterseite der untersten Halbleiterschicht des photonischen III-V-Halbleiterbauelements, z.B. des Absorptionsbereichs oder der Halbleiterkontaktschicht, vollständig oder zumindest zu einem großen Teil, z.B. zu 70%, bedeckt.

Eine punktförmige Anschlusskontaktschicht bedeckt dagegen nur einen geringen Anteil der Oberfläche der untersten Halbleiterschicht des Bauelements, z.B. 20% oder 10%. Es versteht sich, dass die Form, also z.B. der Umfang der punktförmigen Anschlusskontaktschicht beliebig sein kann, z.B. kreisförmig, oval oder mehreckig, beispielsweise quadratisch.

Eine fingerförmige Anschlusskontaktschicht bedeckt die Unterseite der untersten Halbleiterschicht nur teilweise mit einzelnen länglichen, streifenförmigen oder punktförmigen Anschlusskontaktschichtabschnitten und gegebenenfalls einem verbindenden quer verlaufenden oder nur lokalen Anschlusskontaktabschnitt und ist daher für das photonische Halbleiterbauelement die bevorzugte Ausführungsform.

In einer anderen Weiterbildung weisen das erste Halbleiterkontaktgebiet und das Absorptionsgebiet und/oder eine zweite Halbleiterkontaktschicht des photonischen III-V-Halbleiterbauelements eine Verbindung mit wenigstens den Elemente GaAs oder InGaAs auf oder bestehen aus InGaAs oder aus GaAs.

In einer weiteren Ausführungsform weist das stapelförmige photonische III-V-Halbleiterbauelement eine weitere Passivierungsschicht auf, wobei die weitere Passivierungsschicht eine Oberseite der III-V-Halbleiterpassivierungsschicht, eine dem Absorptionsgebiet zugewandte Seitenfläche der III-V-Halbleiterpassivierungsschicht, eine an die Seitenfläche der III-V-Halbleiterpassivierungsschicht angrenzende Oberseite des Absorptionsgebiet und einen Randbereich der Oberseite des erste Halbleiterkontaktgebiets überdeckt.

Bevorzugt umfasst die weitere Passivierungsschicht Si₃N₄ und/oder SiO₂ und/oder SiNOₓ und/oder Polyimid oder besteht aus Si₃N₄ und/oder SiO₂ und/oder SiNOₓ und/oder Polyimid.

In einer weiteren Ausführungsform ist das erste Halbleiterkontaktgebiet durch Implantation oder Diffusion von Fremdatomen, z.B. Zn oder Mg in das Absorptionsgebiet erzeugt. Die Tiefe des ersten Halbleiterkontaktgebiets beträgt mindestens 0,5 µm und höchstens 20 µm oder höchstens 10 µm oder höchstens 5 µm. Die Oberseite des ersten Halbleiterkontaktgebiets weist bevorzugt einen kreisförmigen oder einen ovalen oder einen mehreckigen, z.B. rechteckigen oder achteckigen, Umfang auf.

Es versteht sich, dass die Form der Oberseite, also die Form des Umfangs, gegebenenfalls von einer für einen Implantationsschritt verwendeten Maske erzeugt wird.

In einer weiteren Weiterbildung weist das stapelförmige photonische III-V-Halbleiterbauelement eine metamorphe Pufferschicht auf, wobei die metamorphe Pufferschicht unterhalb der Unterseite des Absorptionsgebiets und oberhalb der ersten metallischen Anschlusskontaktschicht angeordnet ist und an einer dem Absorptionsgebiet zugewandten Oberseite die erste Gitterkonstante und an einer Unterseite eine von der ersten Gitterkonstanten abweichenden zweite Gitterkonstante aufweist.

Vorzugsweise weist die metamorphe Pufferschicht eine Dicke zwischen 2 µm und 5 µm und eine Dotierung zwischen 1•10¹⁷ bis 1•10¹⁹ cm⁻³ auf. Bevorzugt weist die metamorphe Pufferschicht wenigstens drei Halbleiterschichten und höchstens fünfzehn Halbeliterschichten auf. Vorzugsweise ändert sich die Gitterkonstanten der Halbleiterschichten der metamorphen Pufferschicht von Halbleiterschicht zu Halbleiterschicht.

Die metamorphe Pufferschicht dient beispielsweise dazu, das Absorptionsgebiet epitaktisch auf einem Substrat zu erzeugen, welches die zweite Gitterkonstante aufweist. Alternativ ermöglicht die Pufferschicht das Ausbilden einer Halbleiterkontaktschicht aus einem Material mit der zweiten Gitterkonstanten.

In einer weiteren Ausführungsform weist das photonische III-V-Halbleiterbauelement alternativ oder ergänzend eine Substratschicht auf, wobei die Substratschicht unterhalb der Unterseite des Absorptionsgebiets und oberhalb der ersten metallischen Anschlusskontaktschicht angeordnet ist und die erste Gitterkonstante oder eine von der ersten Gitterkonstanten abweichende zweite Gitterkonstante aufweist.

Beispielsweise wurde ein Aufwachssubstrat, auf welchem die Schichten des Halbleiterbauelements aufgewachsen wurde, nicht vollständig bzw. nur teilweise entfernt.

In einer weiteren Ausführungsform weist das stapelförmige photonische III-V-Halbleiterbauelement alternativ oder ergänzend eine Halbleiterzwischenschicht mit einer Dotierstoffkonzentration von 1•10¹⁴ - 1•10¹⁶ cm⁻³ und einer Schichtdicke von höchstens 50 µm oder höchstens 20 µm auf.

Die Halbleiterzwischenschicht ist unterhalb des Absorptionsgebiets und oberhalb einer hochdotierten Halbleiterkontaktschicht des zweiten Leitfähigkeitstyps angeordnet und weist den zweiten Leitfähigkeitstyp auf oder die Halbleiterzwischenschicht ist zwischen dem ersten Halbleiterkontaktgebiet und dem Absorptionsgebiet ausgebildet und weist den ersten Leitfähigkeitstyp auf.

Bevorzugt ist die Halbleiterzwischenschicht zwischen dem sehr niedrig dotierten Absorptionsgebiet und einer hochdotierten Halbleiterkontaktschicht, also dem ersten Halbleiterkontaktgebiet oder einer zweiten Halbleiterkontaktschicht angeordnet, um den Serienwiderstand zu reduzieren, die Durchbruchspannung zu erhöhen und eine bessere thermische Ankopplung zu erreichen.

In einer weiteren Ausführungsform weist das Absorptionsgebiet den zweiten Leitfähigkeitstyp auf und die erste metallische Anschlusskontaktschicht ist mit der Unterseite des Absorptionsgebiets oder mit einer Unterseite einer unterhalb des Absorptionsgebiets angeordneten Pufferschicht oder mit einer Unterseite einer unterhalb des Absorptionsgebiets angeordneten Substratschicht stoffschlüssig verbunden.

Alternativ zu der vorgenannten Ausführungsform weist das photonische III-V-Halbleiterbauelement eine hochdotierte zweite Halbleiterkontaktschicht des zweiten Leitfähigkeitstyps mit einer Dotierstoffkonzentration von mindestens 1•10¹⁷ cm⁻³, einer dem Absorptionsgebiet zugewandten Oberseite und einer Unterseite auf, wobei die zweite Halbleiterkontaktschicht unterhalb des Absorptionsgebiets angeordnet ist und die erste metallische Anschlusskontaktschicht stoffschlüssig mit der Unterseite der zweiten Halbleiterkontaktschicht verbunden ist.

In einer Weiterbildung weist die zweite Halbleiterkontaktschicht eine Schichtdicke von 0,5 µm - 150 µm oder von 0,5 µm - 50 µm oder von 0,5 µm und 10 µm oder von 0,5 µm und 5 µm auf.

In einer weiteren Weiterbildung weist die zweite Halbleiterkontaktschicht die erste Gitterkonstante auf und die Unterseite des Absorptionsgebiets ist bevorzugt stoffschlüssig mit der Oberseite der zweiten Halbleiterkontaktschicht verbunden.

In einer alternativen Weiterbildung weist die Halbleiterkontaktschicht eine von der ersten Gitterkonstanten abweichende zweite Gitterkonstante auf, wobei zwischen der Halbleiterkontaktschicht und dem Absorptionsgebiet eine Pufferschicht mit der ersten Gitterkonstanten an einer dem Absorptionsgebiet zugewandten Oberseite und der zweiten Gitterkonstante an einer der Halbleiterkontaktschicht zugewandten Unterseite angeordnet ist.

In einer weiteren Ausführungsform ist die Halbleiterkontaktschicht als Substratschicht oder als Pufferschicht ausgebildet. Anders ausgedrückt weist eine einzige Halbleiterschicht sowohl die Funktion und Eigenschaften der Halbleiterkontaktschicht als auch der Substratschicht oder der Pufferschicht auf bzw. erfüllt beide Funktionen.

Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. die Abstände und die laterale und die vertikale Erstreckung sind nicht maßstäblich und weisen, sofern nicht anders angegeben, auch keine ableitbaren geometrischen Relationen zueinander auf. Darin zeigt:
- Figur 1a: eine Querschnittansicht einer zweiten Ausführungsform eines stapelförmigen photonischen III-V-Halbleiterbauelements,
- Figur 1b: eine Querschnittansicht einer ersten Ausführungsform eines stapelförmigen photonischen III-V-Halbleiterbauelements,
- Figur 2: eine Aufsicht auf eine Oberseite der ersten Ausführungsform des stapelförmigen photonischen III-V-Halbleiterbauelements,
- Figur 3: eine Querschnittansicht einer dritten Ausführungsform des stapelförmigen photonischen III-V-Halbleiterbau-elements,
- Figur 4: eine Querschnittansicht einer vierten Ausführungsform eines stapelförmigen photonischen III-V-Halbleiterbauelements,
- Figur 5: eine Querschnittansicht einer fünften Ausführungsform eines stapelförmigen photonischen III-V-Halbleiterbauelements,
- Figur 6: eine Querschnittansicht einer sechsten Ausführungsform eines stapelförmigen photonischen III-V-Halbleiterbauelements,
- Figur 7: eine Querschnittansicht einer siebten Ausführungsform eines stapelförmigen photonischen III-V-Halbleiterbauelements,
- Figur 8: eine Aufsicht auf eine Unterseite einer achten Ausführungsform des III-V-Halbleiterbauelements.

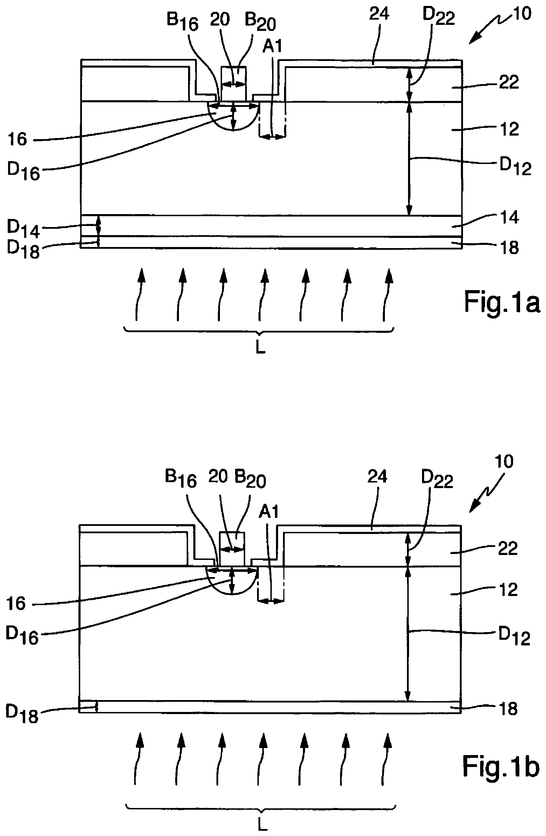

Die Abbildung der Figur 1b zeigt ein stapelförmiges photonisches III-V-Halbleiterbauelement 10 mit einem Absorptionsgebiet 12, einem hochdotierten erste Halbleiterkontaktgebiet 16, einer ersten metallischen Anschlusskontaktschicht 18, einer zweiten metallischen Anschlusskontaktschicht 20 sowie einer III-V-Halbleiterpassivierungsschicht 22.

Das Absorptionsgebiet 12 ist mit Dotierstoffen eines zweiten Leitfähigkeitstyps mit einer niedrigen bis sehr niedrigen Dotierstoffkonzentration von 8•10¹¹ - 5•10¹⁴ cm⁻³ dotiert und weist eine erste Gitterkonstante und eine Schichtdicke D12 von mindestens 80 µm, z.B. 100 µm oder 1000 µm, auf.

An einer Unterseite des Absorptionsgebiets 12 folgt stoffschlüssig die erste metallische Anschlusskontaktschicht 18 ist als dünne planare Metallschicht mit einer Schichtdicke D18 von höchstens 2 µm, z.B. 10 nm. Alternativ - nicht dargestellt - ist die metallische Anschlusskontaktschicht 18 streifenförmig oder fingerförmig oder punktförmig ausgebildet.

Das hochdotierte erste Halbleiterkontaktgebiet 16 weist Dotierstoffe eines ersten Leitfähigkeitstyps mit einer Dotierstoffkonzentration von mindestens 5•10¹⁸ cm⁻³ auf und erstreckt sich von der Oberseite des Absorptionsgebiets 12 wannenförmig mit einer Breite B16 und eine Tiefe D16 in das Absorptionsgebiet 12 hinein, so dass eine Oberseite des erste Halbleiterkontaktgebiet 16 mit der Oberseite des Absorptionsgebiets 12 eine gemeinsame Oberfläche ausbilden.

Die zweite metallische Anschlusskontaktschicht 20 ist auf der Oberseite des ersten Halbleiterkontaktgebiets 16 angeordnet, wobei die metallische Anschlusskontaktschicht 20 einen zumindest näherungsweise konzentrisch angeordneten Teil der Oberseite des zweiten Kontaktgebiets 16 überdeckt. Die zweite metallische Anschlusskontaktschicht 20 ist somit in einer Projektion senkrecht zu der Oberseite des Absorptionsgebiets konzentrisch zu dem zweiten Kontaktgebiet angeordnet.

In einem Abstand A1 zu der Oberseite des hochdotierten ersten Halbleiterkontaktgebiets 16 ist die III-V-Halbleiterpassivierungsschicht 22 auf der Oberseite des Absorptionsgebiets 12 angeordnet.

Die Oberseite der III-V-Halbleiterpassivierungsschicht 22 ist von einer weiteren Passivierungsschicht 24 überdeckt.

Die weitere Passivierungsschicht 24 erstreckt sich außerdem über einen das erste Halbleiterkontaktgebiet 16 umgebenden und nicht von der ersten III-V-Halbleiterpassivierungsschicht 24 überdeckten Teil der Oberseite des Absorptionsgebiets.

Es versteht sich, dass die Begriffe "oben", "oberhalb", "unten" und "unterhalb" nur zur Anordnung der einzelnen Gebiete und Schichten relativ zueinander dienen und keine absolute Richtung angeben. So ist das in Fig. 1b dargestellte photonische Bauelement beispielsweise dazu ausgelegt, von unten kommende Strahlung L zu detektieren.

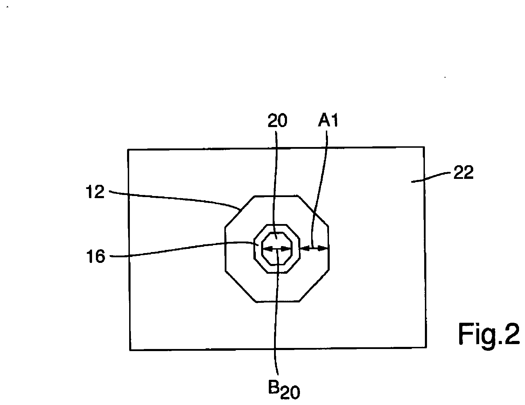

In der Abbildung der Figur 2 ist eine Aufsicht auf die erste Ausführungsform des stapelförmigen photonisches III-V-Halbleiterbauelements dargestellt. Im Folgenden werden nur die Unterschiede zu der Abbildung der Figur 1b erläutert.

Die Oberseite des ersten Halbleiterkontaktgebiets 16 weist einen achteckigen Umfang und einen Durchmesser B16 auf.

Die zweite metallische Anschlusskontaktschicht 20 weist ebenfalls einen achteckigen Umfang und einen Durchmesser B20 kleiner als der Durchmesser B16 auf und ist zu der Oberseite des ersten Halbleiterkontaktgebiets 16 konzentrisch angeordnet.

Die Oberseite des ersten Halbleiterkontaktgebiets 16 ist von einem freiliegenden Abschnitt der Oberseite des Absorptionsgebiets 12 umgeben, wobei der Abschnitt durchgehend die Breite A1 aufweist. Die restliche Oberfläche bzw. Oberseite des Absorptionsgebiets 12 ist vollständig von der III-V-Halbleiterpassivierungsschicht 22 überdeckt, d.h. die III-V-Halbleiterpassivierungsschicht 22 spart einen das erste Halbleiterkontaktgebiet 16 umfassenden Bereich der Oberfläche des Absorptionsgebiets 12 aus.

In nicht dargestellten Ausführungsformen sind der Umfang der zweiten metallischen Anschlusskontaktschicht 20, der Umfang der Oberseite des ersten Halbleiterkontaktgebiets 16 und / oder ein Umfang der Aussparung in der III-V-Halbleiterpassivierungsschicht 22 kreisförmig, z.B. rund oder oval, oder mehreckig, z.B. quadratisch oder rechteckig, ausgebildet.

Es versteht sich, dass die genannten Umfänge nicht alle dieselbe Form aufweisen müssen. Bedingung ist lediglich, dass der Umfang der zweiten metallischen Kontaktschicht 20 in allen Punkten einen Abstand zu dem Umfang der Oberseite des ersten Halbleiterkontaktgebiets 16 aufweist und der Umfang der Aussparung der III-V-Passivierungsschicht 22 in allen Punkten zumindest den ersten Abstand A1 zu dem Umfang der Oberseite des ersten Halbleiterkontaktbereichs 16 aufweist.

Die Abbildung der Figur 1a zeigt eine Querschnittansicht des stapelförmigen photonischen III-V-Halbleiterbauelements in einer zweiten Ausführungsform.

Die Oberseite der III-V-Halbleiterpassivierungsschicht 22 ist von der weiteren Passivierungsschicht 24, z.B. einer Nitridschicht und / oder einer Oxidschicht und / oder einer Polyimidschicht, überdeckt.

Die weitere Passivierungsschicht 24 erstreckt sich außerdem über einen das erste Halbleiterkontaktgebiet 16 umgebenden und nicht von der ersten III-V-Halbleiterpassivierungsschicht 24 überdeckten Teil der Oberseite des Absorptionsgebiets sowie über einen Randbereich der Oberseite des ersten Halbleiterkontaktgebiets 16 und eine zu dem ersten Halbleiterkontaktgebiet 16 hin ausgerichteten Seitenflächen der III-V-Halbleiterpassivierungsschicht 22.

Die zweite metallische Anschlusskontaktschicht 20 überdeckt den frei gebliebenen zentralen Bereich der Oberseite des ersten Halbleiterkontaktgebiets 16 und einen sich anschließenden Bereich der weiteren Passivierungsschicht 24.

Zwischen dem Absorptionsgebiets 12 und der ersten metallischen Anschlusskontaktschicht 18 ist die zweite hoch-dotierte Halbleiterkontaktschicht 14 des zweiten Leitfähigkeitstyps mit einer Dotierstoffkonzentration von mindestens 10¹⁷ cm⁻³ und einer Schichtdicke D14 von höchstens 20 µm oder höchstens 5 µm oder höchstens 2 µm oder höchstens 0,5 µm und jedenfalls größer als 10 nm angeordnet.

Die erste metallische Anschlusskontaktschicht 18 ist als dünne planare Metallschicht mit einer Schichtdicke D18 von höchstens 2 µm, z.B. 10 nm, stoffschlüssig auf einer Unterseite der Halbleiterkontaktschicht 14 ausgebildet. Alternativ - nicht dargestellt - ist die metallische Anschlusskontaktschicht 18 streifenförmig oder fingerförmig oder punktförmig ausgebildet.

In der dargestellten Ausführungsform weist das Absorptionsgebiet 12 entweder den ersten oder den zweiten Leitfähigkeitstyp auf, wobei sich ein p-n Übergang im ersten Fall an der Unterseite des Absorptionsgebiets zu der zweiten Halbleiterkontaktschicht 14 hin ausbildet und sich im zweiten Fall an dem Übergang zwischen dem Absorptionsgebiet 12 und dem wannenförmigen ersten Halbleiterkontaktgebiet ausbildet. Der erste Leitfähigkeitstyp ist n und der zweite Leitfähigkeitstyp ist p oder vice versa. Der zweite Fall ist allerdings nicht durch die Ansprüche abgedeckt.

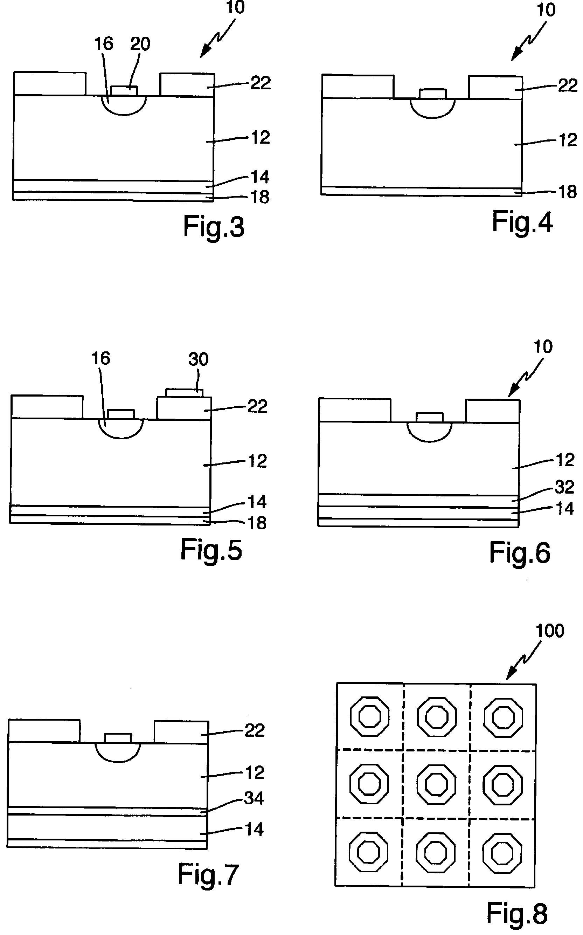

In der Abbildung der Figur 3 ist eine Schnittansicht einer dritten Ausführungsform des stapelförmigen photonischen III-V-Halbleiterbauelements dargestellt. Der Schichtaufbau entspricht dem in der Figur 1a ohne die weitere Passivierungsschicht 24.

In der Abbildung der Figur 7 ist eine Schnittansicht einer siebten Ausführungsform des stapelförmigen photonischen III-V-Halbleiterbauelements dargestellt. Im Folgenden werden nur die Unterschiede zu den Abbildungen der Figuren 1 und 2 erläutert.

Das stapelförmige photonische III-V-Halbleiterbauelement 10 weist zusätzlich zu der zweiten Halbleiterkontaktschicht 14 eine Halbleiterzwischenschicht 34 auf, wobei die Halbleiterzwischenschicht 34 zwischen der Halbleiterkontaktschicht 14 und dem Absorptionsgebiet 12 angeordnet ist, eine Schichtdicke von höchstens 50 µm, den zweiten Leitfähigkeitstyp und eine Dotierstoffkonzentration zwischen 1•10¹⁴ cm⁻³ und 1•10¹⁶ cm⁻³ aufweist.

In der Abbildung der Figur 4 ist eine Schnittansicht einer vierten Ausführungsform des stapelförmigen photonischen III-V-Halbleiterbauelements dargestellt. Im Folgenden werden nur die Unterschiede zu den Abbildungen der Figuren 1 und 3 erläutert.

Das stapelförmige photonische III-V-Bauelement 10 weist keine hochdotierte Halbleiterkontaktschicht 14 auf.

Die Halbleiterzwischenschicht 34 - nicht in der Figur 4 dargestellt - ist zwischen den Absorptionsgebiet 12 und dem wannenförmigen ersten Halbleiterkontaktgebiet 16 angeordnet und weist eine Schichtdicke von höchstens 20 µm und den ersten Leitfähigkeitstyp auf.

In einer nicht dargestellten Ausführungsform weist das III-V-Halbleiterbauelement sowohl die zweite Halbleiterkontaktschicht 14 als auch die Halbleiterzwischenschicht 34 auf.

In der Abbildung der Figur 5 ist eine Schnittansicht einer fünften Ausführungsform des stapelförmigen photonischen III-V-Halbleiterbauelements dargestellt. Im Folgenden werden nur die Unterschiede zu der Abbildung der der Figur 1a erläutert.

Auf einer Oberseite der III-V-Halbleiterpassivierungsschicht 22 des photonischen III-V-Halbleiterbauelements 10 ist eine zumindest gebietsweise ausgebildete dritte metallische Anschlusskontaktschicht 30 angeordnet und mit der Oberseite der III-V-Halbleiterpassivierungsschicht 22 stoffschlüssig verbunden.

Außerdem weist die III-V-Halbleiterpassivierungsschicht 22 den zweiten Leitfähigkeitstyp, das Absorptionsgebiet 12 wie das erste Halbleiterkontaktgebiet 12 den ersten Leitfähigkeitstyp und die zweite Halbleiterkontaktschicht 14 den zweiten Leitfähigkeitstyp auf.

In der Abbildung der Figur 6 ist eine Schnittansicht einer sechsten Ausführungsform des stapelförmigen photonischen III-V-Halbleiterbauelements dargestellt. Im Folgenden werden nur die Unterschiede zu der Abbildung der Figur 1a erläutert.

Das photonische III-V-Halbleiterbauelement 10 weist zusätzlich eine Pufferschicht 32 auf, wobei die Pufferschicht 32 an einer Oberseite die erste Gitterkonstante und an einer Unterseite eine zweite Gitterkonstante aufweist.

Die Oberseite der Pufferschicht 32 ist stoffschlüssig mit der Unterseite des Absorptionsgebiets 12 verbunden und die Unterseite der Pufferschicht 32 ist stoffschlüssig mit der Oberseite der hochdotierten Halbleiterkontaktschicht 14 verbunden. Die Halbleiterkontaktschicht 14 weist die zweite Gitterkonstante auf.

In einer alternativen, nicht dargestellten Ausführungsform weist das photonische III-V-Halbleiterbauelement die Pufferschicht 32, aber keine Halbleiterkontaktschicht 14 auf, so dass die erste metallische Anschlusskontaktschicht 18 stoffschlüssig mit der Unterseite der Pufferschicht 32 verbunden ist.

Ebenfalls nicht dargestellt sind weitere Ausführungsformen, bei denen das photonische III-V-Halbleiterbauelement 10 statt der Pufferschicht 32 eine Substratschicht mit der ersten Gitterkonstanten oder zusätzlich zu der Pufferschicht 32 und unterhalb der Pufferschicht 32 angeordnet eine Substratschicht mit der zweiten Gitterkonstanten aufweist.

Es versteht sich, dass die beiden vorgenannten Ausführungsformen sowohl mit der hochdotierten Halbleiterkontaktschicht als auch ohne die Halbleiterkontaktschicht 14 realisiert werden können.

Es wird angemerkt, dass auch die photonischen III-V-Halbleiterbauelemente in den Ausführungsformen der Figuren 3 bis 8 ebenfalls eine weitere Passivierungsschicht 24 aufweisen können (nicht dargestellt).

In der Abbildung der Figur 8 ist eine Aufsicht auf eine Unterseite des III-V-Halbleiterbauelements in einer achten Ausführungsform dargestellt.

In einer nicht dargestellten fingerförmigen Ausgestaltung der ersten metallischen Anschlusskontaktschicht 18 verlaufen die einzelnen fingerförmigen Abschnitte der ersten Anschlusskontaktschicht 18 parallel zueinander und sind mittels eines quer verlaufenden fingerförmigen Abschnitts elektrisch leitend verbunden.

In Figur 8 ist eine punktförmige Ausgestaltung der ersten metallischen Anschlusskontaktschicht 18 auf der zweiten Halbleiterkontaktschicht 14 dargestellt, wobei die erste Anschlusskontaktschicht 18 einen quadratischen Umfang aufweist und in einer Ecke der Unterseite des Absorptionsgebiets 12 angeordnet ist.

Nicht dargestellt sind Ausführungsformen mit einer punktförmigen Anschlusskontaktschicht 18 mit rechteckigem, mehreckigem, kreisförmigem oder ovalem Umfang und einer beliebigen Position auf der Unterseite des Absorptionsgebiets.

Ebenso wenig dargestellt sind Ausführungsformen bei denen die punktförmige Anschlusskontaktschicht 18 direkt auf dem Absorptionsgebiet 12 oder auf einer anderen Halbleiterzwischenschicht 24 angeordnet ist.

Es versteht sich auch, dass die Ausführungsformen der Figuren miteinander kompatibel sind.

Die vorliegende Erfindung wird allerdings ausschließlich durch die nachfolgenden Ansprüche definiert.

## Patentansprüche

1. Stapelförmiges photonisches III-V-Halbleiterbauelement (10), ausgebildet mit einer n-auf-p oder einer p-auf-n Struktur und aufweisend
- eine zumindest gebietsweise ausgebildete zweite metallische Anschlusskontaktschicht (20),
- ein hochdotiertes erstes Halbleiterkontaktgebiet (16) eines ersten Leitfähigkeitstyps mit einer Dotierstoffkonzentration von mindestens 5•10¹⁸ cm⁻³ und mit einer ersten Gitterkonstanten und einer ersten Energiebandlücke,
- ein Absorptionsgebiet (12) eines zweiten Leitfähigkeitstyps oder des ersten Leitfähigkeitstyps mit einer Dotierstoffkonzentration von 8•10¹¹ - 5•10¹⁴ cm⁻³ und einer Schichtdicke (D12) zwischen 80 µm und 2000 µm, wobei das Absorptionsgebiet (12) die erste Gitterkonstanten aufweist,
- eine zumindest gebietsweise ausgebildete erste metallische Anschlusskontaktschicht (18), wobei
- wenn das Absorptionsgebiet den ersten Leitfähigkeitstyp aufweist, weist das Bauelement eine hoch-dotierte Halbleiterkontaktschicht (14) des zweiten Leitfähigkeitstyps auf, die unterhalb einer Unterseite des Absorptionsgebiets angeordnet und mit einer Oberseite der ersten metallischen Anschlusskontaktschicht verbunden ist,
die Halbleiterkontaktgebiete bzw. Halbleiterschichten des photonischen III-V -Bauelements aus III-V Materialien bestehen,
- das erste Halbleiterkontaktgebiet (16) wannenförmig mit einer Oberseite und einer sich in das Absorptionsgebiet (12) hinein erstreckenden Tiefe (D16) ausgebildet ist,
- die Unterseite der zweiten metallischen Anschlusskontaktschicht (20) stoffschlüssig mit der Oberseite des ersten Halbleiterkontaktgebiets (16) verbunden ist und
- die erste metallische Anschlusskontaktschicht (18) unterhalb einer Unterseite des Absorptionsgebiets (12) angeordnet ist, und
- das stapelförmige photonische III-V-Halbleiterbauelement (10) eine III-V-Halbleiterpassivierungsschicht (22) mit der ersten Gitterkonstanten und einer sich von der ersten Energiebandlücke unterscheidenden zweiten Energiebandlücke aufweist, wobei
- die III-V-Halbleiterpassivierungsschicht (22) den ersten Leitfähigkeitstyp oder den zweiten Leitfähigkeitstyp und eine Dotierstoffkonzentration in einem Bereich zwischen 1•10¹⁴ und 1•10¹⁸ cm⁻³ aufweist,
- die III-V-Halbleiterpassivierungsschicht (22) in einem ersten Abstand (A1) von mindestens 10 µm zu der Oberseite des ersten Halbleiterkontaktgebiets (16) auf der Oberseite des Absorptionsgebiets (12) angeordnet ist und mit der Oberseite des Absorptionsgebiets (12) stoffschlüssig verbunden ist.

2. Stapelförmiges photonisches III-V-Halbleiterbauelement (10) nach Anspruch 1, **dadurch gekennzeichnet, dass** die III-V-Halbleiterpassivierungsschicht (22) eine Schichtdicke (D22) von 0,1 µm - 10 µm aufweist.

3. Stapelförmiges photonisches III-V-Halbleiterbauelement (10) nach einem der vorangegangenen Ansprüche, **dadurch gekennzeichnet, dass** die III-V-Halbleiterpassivierungsschicht (22) InGaP oder AlGaAs oder InGaAsP aufweist oder aus InGaP oder AlGaAs oder InGaAsP besteht.

4. Stapelförmiges photonisches III-V-Halbleiterbauelement (10) nach einem der vorangegangenen Ansprüche, **dadurch gekennzeichnet, dass** der erste Abstand der III-V-Halbleiterpassivierungsschicht (22) zu dem Halbleiterkontaktgebiet (16) mindestens 50% der Schichtdicke des Absorptionsgebiets (12) beträgt.

5. Stapelförmiges photonisches III-V-Halbleiterbauelement (10) nach einem der vorangegangenen Ansprüche, **dadurch gekennzeichnet, dass** die III-V-Halbleiterpassivierungsschicht (22) in einer Projektion senkrecht zu der Oberseite des Halbleiterkontaktgebiets (16) das Halbleiterkontaktgebiet (16) vollständig umschließt.

6. Stapelförmiges photonisches III-V-Halbleiterbauelement (10) nach einem der vorangegangenen Ansprüche, **dadurch gekennzeichnet, dass** das Absorptionsgebiet (12) den ersten Leitfähigkeitstyp und die Halbleiterpassivierungsschicht (22) den zweiten Leitfähigkeitstyp aufweist und die Halbleiterpassivierungsschicht (22) eine zumindest gebietsweise ausgebildete dritte metallischen Anschlusskontaktschicht aufweist, die stoffschlüssig mit einer Oberseite der Halbleiterpassivierungsschicht (22) verbunden ist.

7. Stapelförmiges photonisches III-V-Halbleiterbauelement (10) nach einem der vorangegangenen Ansprüche, **dadurch gekennzeichnet, dass** die III-V-Halbleiterpassivierungsschicht (22) auf dem Absorptionsgebiet (12) und das Absorptionsgebiet (12) auf der hoch-dotierten Halbleiterkontaktschicht (14) oder auf einer Pufferschicht (32) oder auf einer Substratschicht epitaktisch erzeugt ist.

8. Stapelförmiges photonisches III-V-Halbleiterbauelement (10) nach einem der vorangegangenen Ansprüche, **dadurch gekennzeichnet, dass** die erste metallische Anschlusskontaktschicht (18) eine Schichtdicke von 5 nm - 2 µm aufweist.

9. Stapelförmiges photonisches III-V-Halbleiterbauelement (10) nach einem der vorangegangenen Ansprüche, **dadurch gekennzeichnet, dass** die erste metallische Anschlusskontaktschicht (18) flächig oder fingerförmig oder punktförmig ausgebildet ist.

10. Stapelförmiges photonisches III-V-Halbleiterbauelement (10) nach einem der vorangegangenen Ansprüche, **dadurch gekennzeichnet, dass** das erste Halbleiterkontaktgebiet (16) und das Absorptionsgebiet (12) und/oder die hoch-dotierte Halbleiterkontaktschicht (14) GaAs aufweisen oder aus GaAs bestehen.

11. Stapelförmiges photonisches III-V-Halbleiterbauelement (10) nach einem der vorangegangenen Ansprüche, **dadurch gekennzeichnet, dass** das stapelförmige photonische III-V-Halbleiterbauelement (10) eine weitere Passivierungsschicht (24) aufweist, wobei die weitere Passivierungsschicht eine Oberseite der III-V-Halbleiterpassivierungsschicht (22), eine dem Absorptionsgebiet (12) zugewandte Seitenfläche der III-V-Halbleiterpassivierungsschicht (22), eine an die Seitenfläche der III-V-Halbleiterpassivierungsschicht (22) angrenzende Oberseite des Absorptionsgebiet (12) und einen Randbereich der Oberseite des ersten Halbleiterkontaktgebiets (16) überdeckt.

12. Stapelförmiges photonisches III-V-Halbleiterbauelement (10) nach Anspruch 11, **dadurch gekennzeichnet, dass** die weitere Passivierungsschicht (24) Si₃N₄ und / oder SiO₂ und / oder SiNOₓ und/oder Polyimid umfasst oder aus Si₃N₄ und / oder SiO₂ und / oder SiNOₓ und / oder Polyimid besteht.

13. Stapelförmiges photonisches III-V-Halbleiterbauelement (10) nach einem der vorangegangenen Ansprüche, **dadurch gekennzeichnet, dass** das erste Halbleiterkontaktgebiet (16) durch Implantation oder Diffusion von Fremdatomen in das Absorptionsgebiet (12) erzeugt ist.

14. Stapelförmiges photonisches III-V-Halbleiterbauelement (10) nach einem der vorangegangene Ansprüche, **dadurch gekennzeichnet, dass** die Tiefe des ersten Halbleiterkontaktgebiets (16) mindestens 0,5 µm und höchstens 20 µm beträgt.

15. Stapelförmiges photonisches III-V-Halbleiterbauelement (10) nach einem der vorangegangenen Ansprüche, **dadurch gekennzeichnet, dass** die Oberseite des ersten Halbleiterkontaktgebiets (16) einen kreisförmigen oder einen ovalen oder einen mehreckigen Umfang aufweist.

16. Stapelförmiges photonisches III-V-Halbleiterbauelement (10) nach einem der vorangegangenen Ansprüche, **dadurch gekennzeichnet, dass** der erste Leitfähigkeitstyp n ist und der zweite Leitfähigkeitstyp p ist oder dass der erste Leitfähigkeitstyp p ist und der zweite Leitfähigkeitstyp n ist.

17. Stapelförmiges photonisches III-V-Halbleiterbauelement (10) nach einem der vorangegangenen Ansprüche, **dadurch gekennzeichnet, dass** das stapelförmige photonische III-V-Halbleiterbauelement (10) eine Pufferschicht (32) aufweist, wobei die Pufferschicht (32) unterhalb der Unterseite des Absorptionsgebiets (12) und oberhalb der ersten metallischen Anschlusskontaktschicht angeordnet ist und an einer dem Absorptionsgebiet (12) zugewandten Oberseite die erste Gitterkonstante und an einer Unterseite eine von der ersten Gitterkonstanten abweichenden zweite Gitterkonstante aufweist.

18. Stapelförmiges photonisches III-V-Halbleiterbauelement (10) nach einem der vorangegangenen Ansprüche, **dadurch gekennzeichnet, dass** das photonische III-V-Halbleiterbauelement (10) eine Substratschicht aufweist, wobei die Substratschicht unterhalb der Unterseite des Absorptionsgebiets (12) und oberhalb der ersten metallischen Anschlusskontaktschicht angeordnet ist und die erste Gitterkonstante oder eine von der ersten Gitterkonstanten abweichende zweite Gitterkonstante aufweist.

19. Stapelförmiges photonisches III-V-Halbleiterbauelement (10) nach einem der vorangegangenen Ansprüche, **dadurch gekennzeichnet, dass** das stapelförmige photonische III-V-Halbleiterbauelement (10) eine Halbleiterzwischenschicht (34) mit einer Dotierstoffkonzentration von 1•10¹⁴ cm⁻³ - 1•10¹⁶ cm⁻³ und einer Schichtdicke (D34) von höchstens 50 µm aufweist, wobei die Halbleiterzwischenschicht (34) unterhalb des Absorptionsgebiets (12) und oberhalb der hoch-dotierten Halbleiterkontaktschicht (14) des zweiten Leitfähigkeitstyps (14) angeordnet ist und den zweiten Leitfähigkeitstyp aufweist und/oder die Halbleiterzwischenschicht (34) zwischen dem ersten Halbleiterkontaktgebiet (16) und dem Absorptionsgebiet (12) ausgebildet ist und den ersten Leitfähigkeitstyp aufweist.

20. Stapelförmiges photonisches III-V-Halbleiterbauelement (10) nach einem der vorangegangenen Ansprüche, **dadurch gekennzeichnet, dass** die hoch-dotierte Halbleiterkontaktschicht (14) eine Dotierstoffkonzentration von mindestens 1•10¹⁷ cm⁻³ aufweist.

21. Stapelförmiges photonisches III-V-Halbleiterbauelement (10) nach Anspruch20, **dadurch gekennzeichnet, dass** die hoch-dotierte Halbleiterkontaktschicht (14) eine Schichtdicke von 0,5 µm - 150 µm aufweist.

22. Stapelförmiges photonisches III-V-Halbleiterbauelement (10) nach Anspruch 20 oder 21, **dadurch gekennzeichnet, dass** die hoch-dotierte Halbleiterkontaktschicht (14) die erste Gitterkonstante aufweist.

23. Stapelförmiges photonisches III-V-Halbleiterbauelement (10) nach Anspruch 21, **dadurch gekennzeichnet, dass** die Unterseite des Absorptionsgebiets (12) stoffschlüssig mit der Oberseite der hoch-dotierten Halbleiterkontaktschicht (14) verbunden ist.

24. Stapelförmiges photonisches III-V-Halbleiterbauelement (10) nach Anspruch 20 oder 21, **dadurch gekennzeichnet, dass** die hoch-dotierte Halbleiterkontaktschicht (14) eine von der ersten Gitterkonstanten abweichende zweite Gitterkonstante aufweist und zwischen der hoch-dotierten Halbleiterkontaktschicht (14) und dem Absorptionsgebiet (12) eine Pufferschicht (32) mit der ersten Gitterkonstanten an einer dem Absorptionsgebiet (12) zugewandten Oberseite und der zweiten Gitterkonstante an einer der hoch-dotierten Halbleiterkontaktschicht (14) zugewandten Unterseite angeordnet ist.

25. Stapelförmiges photonisches III-V-Halbleiterbauelement (10) nach einem der Ansprüche 20 bis 24, **dadurch gekennzeichnet, dass** die hoch-dotierte Halbleiterkontaktschicht (14) als Substratschicht oder als Pufferschicht (32) ausgebildet ist.

## Claims

1. A stacked photonic III-V semiconductor device (10), configured with an n-on-p or a p-on-n structure and comprising
- a second metallic terminal contact layer (20) formed at least in regions,
- a highly doped first semiconductor contact region (16) of a first conductivity type, having a dopant concentration of at least 5·10¹⁸ cm⁻³, a first lattice constant and a first energy bandgap,
- an absorption region (12) of a second conductivity type or of the first conductivity type, having a dopant concentration of 8·10¹¹ to 5·10¹⁴ cm⁻³ and a layer thickness (D12) between 80 µm and 2000 µm, wherein the absorption region (12) has the first lattice constant,
- a first metallic terminal contact layer (18) formed at least in regions, wherein
- when the absorption region has the first conductivity type, the device comprises a highly doped semiconductor contact layer (14) of the second conductivity type, which is arranged below a bottom side of the absorption region and is connected to a top side of the first metallic terminal contact layer,
- the semiconductor contact regions and/or the semiconductor layers of the photonic III-V device consist of III-V materials,
- the first semiconductor contact region (16) is formed in the shape of a well, has a top side and has a depth (D16) extending into the absorption region (12),
- the bottom side of the second metallic terminal contact layer (20) is materially bonded to the top side of the first semiconductor contact region (16), and
- the first metallic terminal contact layer (18) is arranged below a bottom side of the absorption region (12), and
- the stacked photonic III-V semiconductor device (10) comprises a III-V semiconductor passivation layer (22) having the first lattice constant and a second energy bandgap that differs from the first energy bandgap, wherein
- the III-V semiconductor passivation layer (22) has the first conductivity type or the second conductivity type and has a dopant concentration in a range between 1·10¹⁴ and 1·10¹⁸ cm⁻³,
- the III-V semiconductor passivation layer (22) is arranged on the top side of the absorption region (12) at a first distance (A1) of at least 10 µm from the top side of the first semiconductor contact region (16), and is materially bonded to the top side of the absorption region (12).

2. The stacked photonic III-V semiconductor device (10) according to claim 1, **characterised in that** the III-V semiconductor passivation layer (22) has a layer thickness (D22) of 0.1 µm to 10 µm.

3. The stacked photonic III-V semiconductor device (10) according to any one of the preceding claims, **characterised in that** the III-V semiconductor passivation layer (22) comprises InGaP, AlGaAs or InGaAsP, or consists of InGaP, AlGaAs or InGaAsP.

4. The stacked photonic III-V semiconductor device (10) according to any one of the preceding claims, **characterised in that** the first distance between the III-V semiconductor passivation layer (22) and the semiconductor contact region (16) is at least 50% of the layer thickness of the absorption region (12).

5. The stacked photonic III-V semiconductor device (10) according to any one of the preceding claims, **characterised in that**, in a projection perpendicular to the top side of the semiconductor contact region (16), the III-V semiconductor passivation layer (22) completely surrounds the semiconductor contact region (16).

6. The stacked photonic III-V semiconductor device (10) according to any one of the preceding claims, **characterised in that** the absorption region (12) has the first conductivity type and the semiconductor passivation layer (22) has the second conductivity type, and the semiconductor passivation layer (22) comprises a third metallic terminal contact layer formed at least in regions and materially bonded to a top side of the semiconductor passivation layer (22).

7. The stacked photonic III-V semiconductor device (10) according to any one of the preceding claims, **characterised in that** the III-V semiconductor passivation layer (22) is epitaxially formed on the absorption region (12), and the absorption region (12) is epitaxially formed on the highly doped semiconductor contact layer (14), on a buffer layer (32), or on a substrate layer.

8. The stacked photonic III-V semiconductor device (10) according to any one of the preceding claims, **characterised in that** the first metallic terminal contact layer (18) has a layer thickness of 5 nm to 2 µm.

9. The stacked photonic III-V semiconductor device (10) according to any one of the preceding claims, **characterised in that** the first metallic terminal contact layer (18) has an areal, finger-shaped or point-shaped configuration.

10. The stacked photonic III-V semiconductor device (10) according to any one of the preceding claims, **characterised in that** the first semiconductor contact region (16), the absorption region (12) and/or the highly doped semiconductor contact layer (14) comprise GaAs or consist of GaAs.

11. The stacked photonic III-V semiconductor device (10) according to any one of the preceding claims, **characterised in that** the stacked photonic III-V semiconductor device (10) comprises a further passivation layer (24), wherein the further passivation layer covers a top side of the III-V semiconductor passivation layer (22), a side surface of the III-V semiconductor passivation layer (22) facing the absorption region (12), the top side of the absorption region (12) adjoining the side surface of the III-V semiconductor passivation layer (22), and an edge region of the top side of the first semiconductor contact region (16).

12. The stacked photonic III-V semiconductor device (10) according to claim 11, **characterised in that** the further passivation layer (24) comprises Si₃N₄ and/or SiO₂ and/or SiNOₓ and/or polyimide, or consists of Si₃N₄ and/or SiO₂ and/or SiNOₓ and/or polyimide.

13. The stacked photonic III-V semiconductor device (10) according to any one of the preceding claims, **characterised in that** the first semiconductor contact region (16) is produced by implantation or diffusion of dopant atoms into the absorption region (12).

14. The stacked photonic III-V semiconductor device (10) according to any one of the preceding claims, **characterised in that** the depth of the first semiconductor contact region (16) is at least 0.5 µm and at most 20 µm.

15. The stacked photonic III-V semiconductor device (10) according to any one of the preceding claims, **characterised in that** the top side of the first semiconductor contact region (16) has a circular, oval or polygonal perimeter.

16. The stacked photonic III-V semiconductor device (10) according to any one of the preceding claims, **characterised in that** the first conductivity type is n and the second conductivity type is p, or the first conductivity type is p and the second conductivity type is n.

17. The stacked photonic III-V semiconductor device (10) according to any one of the preceding claims, **characterised in that** the stacked photonic III-V semiconductor device (10) comprises a buffer layer (32), wherein the buffer layer (32) is arranged below the bottom side of the absorption region (12) and above the first metallic terminal contact layer, and has the first lattice constant at a top side facing the absorption region (12) and a second lattice constant differing from the first lattice constant at a bottom side.

18. The stacked photonic III-V semiconductor device (10) according to any one of the preceding claims, **characterised in that** the photonic III-V semiconductor device (10) comprises a substrate layer, wherein the substrate layer is arranged below the bottom side of the absorption region (12) and above the first metallic terminal contact layer, and has the first lattice constant or a second lattice constant differing from the first lattice constant.

19. The stacked photonic III-V semiconductor device (10) according to any one of the preceding claims, **characterised in that** the stacked photonic III-V semiconductor device (10) comprises a semiconductor intermediate layer (34) having a dopant concentration of 1·10¹⁴ cm⁻³ to 1·10¹⁶ cm⁻³ and a layer thickness (D34) of at most 50 µm, wherein the semiconductor intermediate layer (34) is arranged below the absorption region (12) and above the highly doped semiconductor contact layer (14) of the second conductivity type and has the second conductivity type, and/or the semiconductor intermediate layer (34) is formed between the first semiconductor contact region (16) and the absorption region (12) and has the first conductivity type.

20. The stacked photonic III-V semiconductor device (10) according to any one of the preceding claims, **characterised in that** the highly doped semiconductor contact layer (14) has a dopant concentration of at least 1·10¹⁷ cm⁻³.

21. The stacked photonic III-V semiconductor device (10) according to claim 20, **characterised in that** the highly doped semiconductor contact layer (14) has a layer thickness of 0.5 µm to 150 µm.

22. The stacked photonic III-V semiconductor device (10) according to claim 20 or claim 21, **characterised in that** the highly doped semiconductor contact layer (14) has the first lattice constant.

23. The stacked photonic III-V semiconductor device (10) according to claim 21, **characterised in that** the bottom side of the absorption region (12) is materially bonded to the top side of the highly doped semiconductor contact layer (14).

24. The stacked photonic III-V semiconductor device (10) according to claim 20 or claim 21, **characterised in that** the highly doped semiconductor contact layer (14) has a second lattice constant differing from the first lattice constant, and a buffer layer (32) is arranged between the highly doped semiconductor contact layer (14) and the absorption region (12), the buffer layer having the first lattice constant at a top side facing the absorption region (12) and the second lattice constant at a bottom side facing the highly doped semiconductor contact layer (14).

25. The stacked photonic III-V semiconductor device (10) according to any one of claims 20 to 24, **characterised in that** the highly doped semiconductor contact layer (14) is formed as a substrate layer or as a buffer layer (32).

## Revendications

1. Dispositif semi-conducteur photonique III-V à structure empilée (10), réalisé selon une structure n sur p ou p sur n et comprenant
- une deuxième couche de contact métallique de raccordement (20), formée au moins par zones,
- une première région de contact semi-conductrice fortement dopée (16) d'un premier type de conductivité, présentant une concentration en dopants d'au moins 5·10¹⁸ cm⁻³, une première constante de réseau et une première largeur de bande interdite,
- une région d'absorption (12) d'un deuxième type de conductivité ou du premier type de conductivité, présentant une concentration en dopants de 8·10¹¹ à 5·10¹⁴ cm⁻³ et une épaisseur de couche (D12) comprise entre 80 µm et 2000 µm, la région d'absorption (12) présentant la première constante de réseau,
- une première couche de contact métallique de raccordement (18), formée au moins par zones, dans lequel
- lorsque la région d'absorption présente le premier type de conductivité, le dispositif comprend une couche de contact semi-conductrice fortement dopée (14) du deuxième type de conductivité, disposée sous une face inférieure de la région d'absorption et reliée à une face supérieure de la première couche de contact métallique de raccordement,
- les régions de contact semi-conductrices et/ou les couches semi-conductrices du dispositif photonique III-V sont constituées de matériaux III-V,
- la première région de contact semi-conductrice (16) est réalisée en forme de puits, présente une face supérieure et une profondeur (D16) s'étendant dans la région d'absorption (12),
- la face inférieure de la deuxième couche de contact métallique de raccordement (20) est reliée par continuité de matière à la face supérieure de la première région de contact semi-conductrice (16), et
- la première couche de contact métallique de raccordement (18) est disposée sous une face inférieure de la région d'absorption (12), et
- le dispositif semi-conducteur photonique III-V à structure empilée (10) comprend une couche de passivation semi-conductrice III-V (22) présentant la première constante de réseau et une deuxième largeur de bande interdite différente de la première largeur de bande interdite, dans lequel
- la couche de passivation semi-conductrice III-V (22) présente le premier type de conductivité ou le deuxième type de conductivité et une concentration en dopants comprise entre 1·10¹⁴ et 1·10¹⁸ cm⁻³,
- la couche de passivation semi-conductrice III-V (22) est disposée sur la face supérieure de la région d'absorption (12), à une première distance (A1) d'au moins 10 µm de la face supérieure de la première région de contact semi-conductrice (16), et est reliée par continuité de matière à la face supérieure de la région d'absorption (12).

2. Dispositif semi-conducteur photonique III-V à structure empilée (10) selon la revendication 1, **caractérisé en ce que** la couche de passivation semi-conductrice III-V (22) présente une épaisseur de couche (D22) de 0,1 µm à 10 µm.

3. Dispositif semi-conducteur photonique III-V à structure empilée (10) selon l'une quelconque des revendications précédentes, **caractérisé en ce que** la couche de passivation semi-conductrice III-V (22) comprend de l'InGaP, de l'AlGaAs ou de l'InGaAsP, ou est constituée d'InGaP, d'AlGaAs ou d'InGaAsP.

4. Dispositif semi-conducteur photonique III-V à structure empilée (10) selon l'une quelconque des revendications précédentes, **caractérisé en ce que** la première distance entre la couche de passivation semi-conductrice III-V (22) et la région de contact semi-conductrice (16) est d'au moins 50 % de l'épaisseur de couche de la région d'absorption (12).

5. Dispositif semi-conducteur photonique III-V à structure empilée (10) selon l'une quelconque des revendications précédentes, **caractérisé en ce que**, dans une projection perpendiculaire à la face supérieure de la région de contact semi-conductrice (16), la couche de passivation semi-conductrice III-V (22) entoure complètement la région de contact semi-conductrice (16).

6. Dispositif semi-conducteur photonique III-V à structure empilée (10) selon l'une quelconque des revendications précédentes, **caractérisé en ce que** la région d'absorption (12) présente le premier type de conductivité et la couche de passivation semi-conductrice (22) présente le deuxième type de conductivité, et la couche de passivation semi-conductrice (22) comprend une troisième couche de contact métallique de raccordement formée au moins par zones et reliée par continuité de matière à une face supérieure de la couche de passivation semi-conductrice (22).

7. Dispositif semi-conducteur photonique III-V à structure empilée (10) selon l'une quelconque des revendications précédentes, **caractérisé en ce que** la couche de passivation semi-conductrice III-V (22) est formée par épitaxie sur la région d'absorption (12), et la région d'absorption (12) est formée par épitaxie sur la couche de contact semi-conductrice fortement dopée (14), sur une couche tampon (32) ou sur une couche de substrat.

8. Dispositif semi-conducteur photonique III-V à structure empilée (10) selon l'une quelconque des revendications précédentes, **caractérisé en ce que** la première couche de contact métallique de raccordement (18) présente une épaisseur de couche de 5 nm à 2 µm.

9. Dispositif semi-conducteur photonique III-V à structure empilée (10) selon l'une quelconque des revendications précédentes, **caractérisé en ce que** la première couche de contact métallique de raccordement (18) présente une configuration surfacique, en forme de doigt ou ponctuelle.

10. Dispositif semi-conducteur photonique III-V à structure empilée (10) selon l'une quelconque des revendications précédentes, **caractérisé en ce que** la première région de contact semi-conductrice (16), la région d'absorption (12) et/ou la couche de contact semi-conductrice fortement dopée (14) comprennent du GaAs ou sont constituées de GaAs.

11. Dispositif semi-conducteur photonique III-V à structure empilée (10) selon l'une quelconque des revendications précédentes, **caractérisé en ce que** le dispositif semi-conducteur photonique III-V à structure empilée (10) comprend une couche de passivation supplémentaire (24), la couche de passivation supplémentaire recouvrant une face supérieure de la couche de passivation semi-conductrice III-V (22), une surface latérale de la couche de passivation semi-conductrice III-V (22) tournée vers la région d'absorption (12), la face supérieure de la région d'absorption (12) adjacente à la surface latérale de la couche de passivation semi-conductrice III-V (22), et une région marginale de la face supérieure de la première région de contact semi-conductrice (16).

12. Dispositif semi-conducteur photonique III-V à structure empilée (10) selon la revendication 11, **caractérisé en ce que** la couche de passivation supplémentaire (24) comprend du Si₃N₄ et/ou du SiO₂ et/ou du SiNOₓ et/ou du polyimide, ou est constituée de Si₃N₄ et/ou de SiO₂ et/ou de SiNOₓ et/ou de polyimide.

13. Dispositif semi-conducteur photonique III-V à structure empilée (10) selon l'une quelconque des revendications précédentes, **caractérisé en ce que** la première région de contact semi-conductrice (16) est produite par implantation ou diffusion d'atomes dopants dans la région d'absorption (12).

14. Dispositif semi-conducteur photonique III-V à structure empilée (10) selon l'une quelconque des revendications précédentes, **caractérisé en ce que** la profondeur de la première région de contact semi-conductrice (16) est d'au moins 0,5 µm et d'au plus 20 µm.

15. Dispositif semi-conducteur photonique III-V à structure empilée (10) selon l'une quelconque des revendications précédentes, **caractérisé en ce que** la face supérieure de la première région de contact semi-conductrice (16) présente un périmètre circulaire, ovale ou polygonal.

16. Dispositif semi-conducteur photonique III-V à structure empilée (10) selon l'une quelconque des revendications précédentes, **caractérisé en ce que** le premier type de conductivité est n et le deuxième type de conductivité est p, ou le premier type de conductivité est p et le deuxième type de conductivité est n.

17. Dispositif semi-conducteur photonique III-V à structure empilée (10) selon l'une quelconque des revendications précédentes, **caractérisé en ce que** le dispositif semi-conducteur photonique III-V à structure empilée (10) comprend une couche tampon (32), la couche tampon (32) étant disposée sous la face inférieure de la région d'absorption (12) et au-dessus de la première couche de contact métallique de raccordement, et présentant la première constante de réseau au niveau d'une face supérieure tournée vers la région d'absorption (12) et une deuxième constante de réseau différente de la première constante de réseau au niveau d'une face inférieure.

18. Dispositif semi-conducteur photonique III-V à structure empilée (10) selon l'une quelconque des revendications précédentes, **caractérisé en ce que** le dispositif semi-conducteur photonique III-V (10) comprend une couche de substrat, la couche de substrat étant disposée sous la face inférieure de la région d'absorption (12) et au-dessus de la première couche de contact métallique de raccordement, et présentant la première constante de réseau ou une deuxième constante de réseau différente de la première constante de réseau.

19. Dispositif semi-conducteur photonique III-V à structure empilée (10) selon l'une quelconque des revendications précédentes, **caractérisé en ce que** le dispositif semi-conducteur photonique III-V à structure empilée (10) comprend une couche intermédiaire semi-conductrice (34) présentant une concentration en dopants de 1·10¹⁴ cm⁻³ à 1·10¹⁶ cm⁻³ et une épaisseur de couche (D34) d'au plus 50 µm, la couche intermédiaire semi-conductrice (34) étant disposée sous la région d'absorption (12) et au-dessus de la couche de contact semi-conductrice fortement dopée (14) du deuxième type de conductivité et présentant le deuxième type de conductivité, et/ou la couche intermédiaire semi-conductrice (34) étant formée entre la première région de contact semi-conductrice (16) et la région d'absorption (12) et présentant le premier type de conductivité.

20. Dispositif semi-conducteur photonique III-V à structure empilée (10) selon l'une quelconque des revendications précédentes, **caractérisé en ce que** la couche de contact semi-conductrice fortement dopée (14) présente une concentration en dopants d'au moins 1·10¹⁷ cm⁻³.

21. Dispositif semi-conducteur photonique III-V à structure empilée (10) selon la revendication 20, **caractérisé en ce que** la couche de contact semi-conductrice fortement dopée (14) présente une épaisseur de couche de 0,5 µm à 150 µm.

22. Dispositif semi-conducteur photonique III-V à structure empilée (10) selon la revendication 20 ou la revendication 21, **caractérisé en ce que** la couche de contact semi-conductrice fortement dopée (14) présente la première constante de réseau.

23. Dispositif semi-conducteur photonique III-V à structure empilée (10) selon la revendication 21, **caractérisé en ce que** la face inférieure de la région d'absorption (12) est reliée par continuité de matière à la face supérieure de la couche de contact semi-conductrice fortement dopée (14).

24. Dispositif semi-conducteur photonique III-V à structure empilée (10) selon la revendication 20 ou la revendication 21, **caractérisé en ce que** la couche de contact semi-conductrice fortement dopée (14) présente une deuxième constante de réseau différente de la première constante de réseau, et une couche tampon (32) est disposée entre la couche de contact semi-conductrice fortement dopée (14) et la région d'absorption (12), la couche tampon présentant la première constante de réseau au niveau d'une face supérieure tournée vers la région d'absorption (12) et la deuxième constante de réseau au niveau d'une face inférieure tournée vers la couche de contact semi-conductrice fortement dopée (14).

25. Dispositif semi-conducteur photonique III-V à structure empilée (10) selon l'une quelconque des revendications 20 à 24, **caractérisé en ce que** la couche de contact semi-conductrice fortement dopée (14) est réalisée sous la forme d'une couche de substrat ou d'une couche tampon (32).
